# EUROPÄISCHE PATENTSCHRIFT

(11) **EP 2 191 705 B1**
(45) Veröffentlichungstag und Bekanntmachung des Hinweises auf die Patenterteilung: **27.02.2013**
(21) Anmeldenummer: 08801686.0
(22) Anmeldetag: 25.08.2008
(51) Int. Cl.: H05K 7/14, H05K 7/20

(54) **Gehäuse**
Housing
Boîtier

(30) Priorität: 14.09.2007 DE 102007043989
(43) Veröffentlichungstag der Anmeldung: 02.06.2010
(73) Patentinhaber: SEW-EURODRIVE GmbH & Co. KG, 76646 Bruchsal (DE)
(72) Erfinder: POLJAK, Anton, 76299 Karlsruhe (DE); PISAR, Sascha, 76185 Karlsruhe (DE)
(86) Internationale Anmeldenummer: PCT/EP2008/006955
(87) Internationale Veröffentlichungsnummer: WO 2009/036863

(56) Entgegenhaltungen:
- DE-A1- 3 544 141
- DE-A1-102004 046 232
- FR-A1- 2 627 091
- GB-A- 668 482
- NL-C2- 1 023 528
- US-A- 2 744 202

## Beschreibung

Die Erfindung betrifft ein Gehäuse.

Kühlkörper zur Entwärmung von wärmeerzeugenden Bauelementen sind mit Kühlstäben oder mit Kühlrippen ausgeführt. Diese erhöhen die Oberfläche und verbessern die Wärmeabfuhr erheblich.

Aus der GB 668 482 A ist eine Elektromotorkonstruktion bekannt, wobei ein gekrümmt ausgeführtes Gehäuse offenbart ist

Aus der US 2 744 202 A ist ein Motor mit einem zylindrischen Ausßenoberflächenabschnitt bekannt.

Aus der DE 35 44 141 A1 ist ein polymerisches Wetterschutzgehäuse für eine elektrische Anordnung bekannt

Aus der DE 10 2004 046232 A1 ist eine Antriebskomponente mit einem Gehäuse, das zumindest eine Kühlvorrichtung umfasst, wobei das Gehaeuse eine selbstreinigende Oberfläche aufweist.

Der Erfindung liegt die Aufgabe zugrunde, Vorrichtungen für den Nassbereich von Anlagen weiterzubilden.

Erfindungsgemäß wird die Aufgabe bei dem Gehäuse nach den in Anspruch 1 angegebenen Merkmalen gelöst.

Wichtige Merkmale der Erfindung bei dem Gehäuse sind, dass es zumindest ein Gehäuseteil umfasst, für den Einsatz im Hygienic-Bereich, beispielsweise in einem Nassbereich,
wobei das Gehäuse die Leistungshalbleiter eines Wechselrichters gehäusbildend umgibt und wärmeleitend mit den wärmeerzeugenden Leistungshalbleitern verbunden ist,
wobei das Gehäuse an seiner äußeren Oberfläche regelmäßig angeordnete, jeweils gleichförmige Erhebungen aufweist,
wobei die Oberfläche derart gestaltet ist, dass an jedem Punkt der Oberfläche die Krümmung kleiner ist als ein maximaler Wert, wobei die Krümmung dem Kehrwert des Krümmungsradius entspricht und das Vorzeichen der Krümmung positiv ist, wenn eine Vertiefung vorliegt, und negativ ist, wenn eine Erhebung vorliegt, so dass flüssige Reinigungsmittel an jede Stelle der Oberfläche gelangen und von dort abfliessen können,
- wobei die Erhebungen halbkugelförmig ausgeführt sind,
- oder wobei die Oberfläche wellenförmig ausgeführt ist, insbesondere in zwei zueinander senkrecht vorgesehenen Tangentialrichtungen der Grundfläche, also einer gedachten Grundfläche in den Bereichen der Erhebungen, die der Oberfläche entsoricht in Bereichen zwischen den Erhebungen,
- oder wobei die Oberfläche gleich ist zu einer Fläche, die durch z = sin(x) sin(y) oder z= sin(SQR(x^2 +y^2))in einem kartesischen Koordinatensystem mit Koordinaten x, y und z definiert ist, wobei SQR die Wurzelfunktion ist.

Von Vorteil ist dabei, dass das Gerät im Hygienic-Bereich, beispielsweise ein Nassbereich, einsetzbar ist. Denn die Oberfläche weist somit einen Minimalradius auf, der geeignet wählbar ist, so dass Reinigungsmittel, insbesondere Waschflüssigkeit, an alle Stellen der Oberfläche gelangt und von dort abfließt. Somit sind Schmutzpartikel, die an einem Punkt der Oberfläche sitzen leicht, schnell und einfach reinigbar. Die Waschflüssigkeit und das Material der Oberfläche ist außerdem derart wählbar, dass die zugehörige Oberflächenspannung derart vorsehbar ist, dass die Flüssigkeit überall leicht abfließt, insbesondere bilden sich Perlen von Flüssigkeitstropfen mit einer geringen Berührfläche zur Oberfläche hin. Somit haften diese Tropfen nur gering und sind schon durch kleine Hangabtriebskräfte oder Luftströmungen bewegbar. Somit ist die Oberfläche leicht reinigbar.

Bei einer vorteilhaften Ausgestaltung ist das Gehäuseteil mit wärmeerzeugenden Bauelementen wärmeleitend verbunden, insbesondere zur Wärmeabfuhr an die Umgebung, wobei das Gehäuse zumindest auch die Bauelemente gehäusebildend umgibt. Von Vorteil ist dabei, dass das Gehäuse einerseits Schutzfunktion andererseits Entwärmungsfunktion aufweist. Die Oberflächenvergrößerung ist in einfacher Weise erreicht und das Gehäuse ist leicht reinigbar. Somit sind im Gehäuseinneren ein Umrichter ebenso wie ein Elektromotor oder ein Getriebe vorsehbar. Die jeweiligen wärmeerzeugenden Bauelemente sind mit dem Gehäuse verbindbar, insbesondere wärmeleitend.

Bei einer vorteilhaften Ausgestaltung ist die Oberfläche derart gestaltet, dass an jedem Punkt der Oberfläche die Krümmung endlich ist, insbesondere also kleiner ist als ein maximaler Wert und größer ist als ein minimaler Wert, wobei der minimale Wert negatives Vorzeichen hat. Von Vorteil ist dabei, dass Vertiefungen nur mit einem minimalen Radius ausführbar sind. Kleinere Vertiefungen sind nicht ausführbar. Erhebungen hingegen sind mit sehr kleinem Radius ausführbar. Auf diese Weise gibt es also keine Spalte oder Vertiefungen, in denen Schmutz sozusagen gefangen ist und nicht oder nur aufwendig zu entfernen ist. Bei der erfindungsgemäßen Oberfläche ist die Reinigung schnell und einfach ausführbar, da Reinigungsmittel schnell abfließt und nirgends festsitzen kann.

Bei einer vorteilhaften Ausgestaltung sind der maximale Wert und der minimale Wert betragsmäßig gleich groß. Von Vorteil ist dabei, dass ein gefälliges Design bei leicht reinigbarer Oberfläche ausführbar ist.

Wie bereits erwähnt ist das Vorzeichen der Krümmung positiv, wenn die Richtung der Hauptnormale am Oberflächenpunkt in die Umgebung weist, also eine Vertiefung vorliegt, und negativ, wenn die Richtung der Hauptnormale am Oberflächenpunkt ins Gehäuseinnere weist, also eine Erhebung vorliegt. Von Vorteil ist dabei, dass Erhebungen negative und Vertiefungen positive Krümmungswerte zuordenbar sind und somit positive Krümmungswerte bis zu einem maximalen Krümmungswert vorgesehen sind. Negative Krümmungswerte sind hingegen unbeschränkt. Erhebungen dürfen als sehr kleine Krümmungen, ähnlich zu Knicken, aufweisen.

Bei einer vorteilhaften Ausgestaltung ist nach DIN-EN 1672-2 und/oder DIN-EN ISO 14159 ausgeführt. Von Vorteil ist dabei, dass Normen eingehalten werden in einfacher Weise. Auf diese Weise ist das Gerät und das Gehäuse einsetzbar in Nassbereichen und Bereichen, wo es auf ein sogenanntes hygienisches Design ankommt.

Bei einer vorteilhaften Ausgestaltung ist die Oberfläche derart gestaltet, dass nur Erhebungen aus einer Grundfläche heraus und keine Versteifungen ausgeführt sind, insbesondere aus einer Grundfläche, welche einer gedachten Grundfläche in den Bereichen der Erhebungen entspricht und welche in Bereichen zwischen den Erhebungen der konkreten Oberfläche entspricht. Von Vorteil ist dabei, dass eine einfache Herstellung ausführbar ist.

Bei einer vorteilhaften Ausgestaltung ist die Grundfläche eben oder konvex ausgeführt ist. Von Vorteil ist dabei, dass Flüssigkeiten einfach und schnell abfließen. Insbesondere bildet sich kein See oder stehender Flüssigkeitsbereich. Denn es ist für Flüssigkeiten keine stabile Umgebung ausgebildet. Somit fließt die Flüssigkeit, insbesondere auch Reinigungsmittel, ab.

Bei einer vorteilhaften Ausgestaltung weist die Grundfläche eine einheitliche Krümmung auf. Von Vorteil ist dabei, dass die Fertigung einfach ist und wiederum kein Festsetzen von Flüssigkeit auftreten kann.

Bei einer vorteilhaften Ausgestaltung ist die Oberfläche derart gestaltet, dass an jedem Punkt der Oberfläche die Krümmung einen Wert aufweist, der aus einem Intervall zwischen zwei negativen Werten vorgesehen ist. Von Vorteil ist dabei, dass wiederum ein Ausbilden eines stehenden Flüssigkeitsbereichs verhinderbar ist.

Bei einer vorteilhaften Ausgestaltung unterscheiden sich die beiden negativen Werte betragsmäßig um weniger als 50 Prozent, insbesondere 10 Prozent. Von Vorteil ist dabei, dass eine im Wesentlichen gleichförmig gekrümmte Grundfläche, also auch einfach zu fertigende und Wasser ableitende Oberfläche ausformbar ist.

Bei einer vorteilhaften Ausgestaltung weist die Oberfläche regelmäßig angeordnete jeweils gleichförmige Erhebungen aus der Grundfläche heraus auf. Von Vorteil ist dabei, dass die Fertigung einfach ausführbar ist und dass eine über die Oberfläche gesehen gleichstarke Entwärmung gewährleistbar ist.

Bei einer vorteilhaften Ausgestaltung ist die Oberfläche wellenförmig ausgeführt, insbesondere in zwei zueinander senkrecht vorgesehenen Tangentialrichtungen der Grundfläche. Insbesondere ist die Oberfläche gleich oder ähnlich zu einer Fläche, die durch z = sin(x) sin(y) oder z= sin(SQR(x^2 +y^2))in einem kartesischen Koordinatensystem mit Koordinaten x, y und z definiert ist und SQR die Wurzelfunktion ist. Von Vorteil ist dabei, dass die Fertigung einfach ist und ein stetig differenzierbarer Verlauf wählbar ist. Außerdem ist ein isotroper Verlauf und somit eine unabhängig von der Einbaulage gleich gute Entwärmung gewährleistbar.

Wichtige Merkmale bei dem Gerät sind, dass das Gehäuse wärmeleitend mit wärmeerzeugenden Bauelementen verbunden ist, wobei das Gehäuse die Bauelemente gehäusebildend umgibt, insbesondere wobei die Bauelemente Leistungshalbleiter sind, insbesondere Leistungshableiter eines Wechselrichters. Von Vorteil ist dabei, dass eine Entwärmung verschiedenartiger Bauelemente, insbesondere Halbleiter und elektrische Statorwicklungen und/oder mechanische Getriebestufen, ausführbar ist, insbesondere am selben Teil.

Bei einer vorteilhaften Ausgestaltung umfasst das Gehäuseteil ein Lager einer Rotorwelle eines vom Gehäuse umfassten Elektromotors und/oder ein Lager einer Abtriebswelle eines vom Gehäuse umfassten Getriebes. Von Vorteil, ist dabei, dass ein einziges Gehäuseteil zur Entwärmung und zum Ableiten von Drehmoment als Drehmomentstütze verwendbar ist.

Bei einer vorteilhaften Ausgestaltung sind die Erhebungen auch isotrop, insbesondere isotrop innerhalb der Tangentialrichtungen der Grundfläche im Bereich der Erhebung, ausgeführt. Somit ist das Gerät in verschiedenen Einbaulagen gleich gut entwärmbar.

Bei einer vorteilhaften Ausgestaltung sind das Gehäuseteil Stator, Rotor und/oder Getriebestufe Bauelemente, die über das Gehäuseteil entwärmt werden. Von Vorteil ist dabei, dass in ihrer physikalischen Funktions- und Wirkweise verschiedenartige Wärmequellen entwärmbar sind.

Bei einer vorteilhaften Ausgestaltung ist die Oberfläche mit einer Antihaftbeschichtung zur Verringerung der Oberflächenspannung versehen. Von Vorteil ist dabei, dass Flüssigkeiten, wie Wasser, wässrige Lösungen und/oder Reinigungsmittel, besonders gut abfließen.

Bei einer vorteilhaften Ausgestaltung ist als Antihaftbeschichtung eine Fluorpolymerbeschichtung vorgesehen. Von Vorteil ist dabei, dass die Oberflächenspannung zu den genannten Flüssigkeiten stark verringert ist.

Bei einer vorteilhaften Ausgestaltung ist die Antihaftbeschichtung über einer Verstärkungsschicht und/oder Verbindungsschicht angeordnet, die auf dem Gehäuseteil, insbesondere Aluminium-Gehäuseteil oder Stahl-Gehäuseteil, aufgebracht ist oder sind. Von Vorteil ist dabei, dass mechanische Spannungen zwischen Aluminium oder Stahl und der Antihaftschicht verringerbar sind.

In Zusammenwirkung der Antihaftschicht mit einer gekrümmten Grundfläche mit insgesamt negativer endlicher nicht-verschwindender Krümmung ergibt sich ein besonders gutes Abfließen. Insbesondere ist mittels der Beschichtung auch ein betragsmäßig kleiner Krümmungswert ermöglicht und dabei trotzdem ein gutes Abfließen gewährleistbar.

Weitere Vorteile ergeben sich aus den Unteransprüchen.

### Bezugszeichenliste

1 Gehäuseteil
2 Erhebungen
3 Übergangsbereich

Die Erfindung wird nun anhand von Abbildungen näher erläutert:

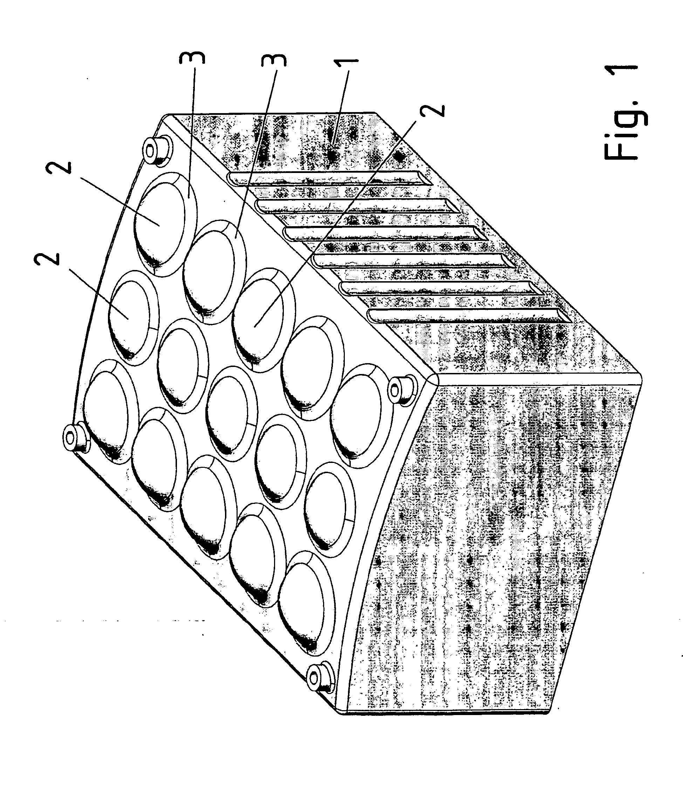

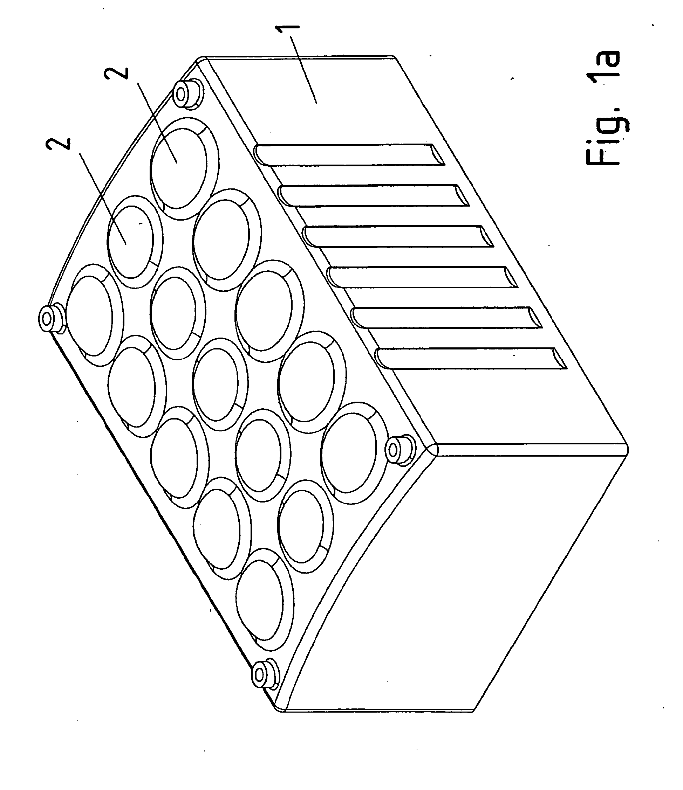

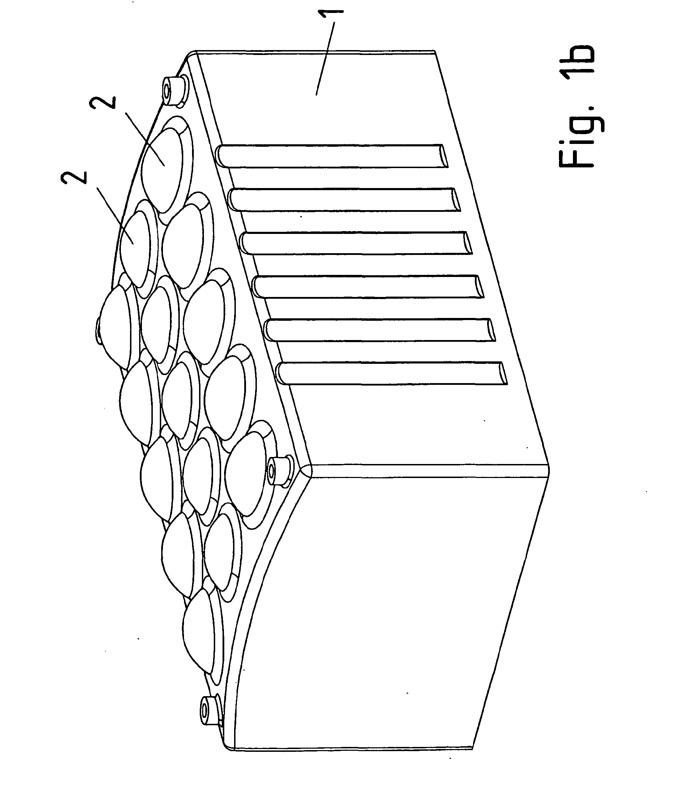

In der Figur 1 ist ein Gehäuseteil 1 eines erfindungsgemäßen Gehäuses, insbesondere eines Elektrogeräts, in Schrägansicht gezeigt. In der Figur 1a ist eine andere zeichnerische Darstellung hierzu gewählt. In der Figur 1 b ist ein anderer Blickwinkel gewählt als in Figur 1a.

Das Gehäuseteil 1 weist Erhebungen 2 auf an seiner äußeren Oberfläche. Die Erhebungen sind halbkugelförmig ausgeführt und erheben sich aus einer Grundfläche, die leicht gekrümmt, also mit einer sehr kleinen negativen Krümmung ausgeführt ist. Zwischen der Grundfläche und den Halbkugelförmigen Erhebungen sind Übergangsbereiche 3 mit positiver Krümmung angeordnet. Diese weisen einen möglichst einen Minimaldurchmesser oder Minimalradius nicht unterschreitenden Durchmesser auf. Somit ist die Krümmung an der gesamten Oberfläche stets kleiner als ein maximaler positiver endlicher Krümmungswert.

In einem weiteren Ausführungsbeispiel sind statt der Erhebungen 2 halbkugelförmige Vertiefungen ausgeführt und die Übergangsbereiche durch eine etwas abgerundete Kante ersetzt. Die Grundfläche weist somit wiederum den negativen kleinen Krümmungswert auf, der betragsmäßig in etwa eine Größenordnung kleiner ist als die Krümmung der halbkugelförmigen Vertiefungen. Diese ist dabei positiv, die Krümmung der Kante jedoch mit einem negativen, betragsmäßig sehr großen Krümmungswert. Somit ist auch hier ein maximaler positiver Krümmungswert nicht überschritten.

Die Krümmung an jedem Punkt der äußeren Oberfläche ist also kleiner als derjenige Wert der Krümmung, welcher zu diesem Minimalradius gehört.

Unter Krümmung wird hierbei der Kehrwert des Krümmungsradius verstanden, wobei die Richtung der Normale als Vorzeichen für die Krümmung verwendet werden soll.

Wird also, wie in der Figur 1, eine Vertiefung in der Oberfläche vorgesehen, ist die Krümmung positiv, da die Normale vom Oberflächenpunkt zum Mittelpunkt des Schmiegkreises, also zum Äußeren des Gehäuseteils, zeigt. Der Betrag der Krümmung ist der Kehrwert des Krümmungsradius.

Wird eine Erhebung der Oberfläche ausgeführt, beträgt die Krümmung wertmäßig den Kehrwert des Krümmungsradius und bekommt ein negatives Vorzeichen, da die Normale ins Innere der Materialoberfläche zeigt. Die Normale zeigt dabei vom Oberflächenpunkt zum Mittelpunkt des Schmiegkreises, also ins Innere des Gehäuseteils.

Die erfindungsgemäße Krümmung darf also auch Null betragen oder beliebig kleine negative Werte aufweisen. Somit ist gewährleistet, dass die Reinigung stets einfach und sicher an jedem Punkt der Oberfläche gewährleistbar ist. Denn Erhebungen sind mit beliebig kleinem Radius ausgeführt, Vertiefungen nur bis zu einem Minimalradius. Es kann sich also keine Flüssigkeit oder ein Feststoff festsetzen in einer Vertiefung. Alle Punkte der Oberfläche sind leicht reinigbar.

In einem ersten erfindungsgemäßen Ausführungsbeispiel ist die Vorrichtung ein Feldgerät, welches in einem Nassbereich einer Anlage installierbar ist. Die Anlage ist beispielhaft eine Anlage zur Erzeugung von Nahrungsmitteln oder Anlage aus der Getränkeindustrie, beispielhaft zum Abfüllen und/oder Etikettieren von Flaschen.

In einem weiteren erfindungsgemäßen Ausführungsbeispiel nimmt die Krümmung nur endliche Werte zwischen einem negativen minimalen Wert und dem positiven maximalen Wert an, welcher zu dem Minimalradius gehört. Beispielhaft sieht die Oberfläche wellenförmig aus, wobei sinusförmige Wellenverläufe in einer Richtung entlang der Oberfläche und ebenso in der hierzu senkrechten Richtung vorgesehen sind.

In den genannten Fällen ist durch die Vertiefungen in der Oberfläche eine Vergrößerung der Oberfläche ausgeführt, wenn man eine ebene Oberfläche als Vergleich wählt.

Bei Verwendung von Halbkugeln als Vertiefungen ist der Bereich der Grundfläche der Halbkugel um den Faktor 2 vergrößert.

## Patentansprüche

1. Gehäuse, umfassend zumindest ein Gehäuseteil (1), für den Einsatz im Hygienic-Bereich, beispielsweise in einem Nassbereich,
wobei das Gehäuse die Leistungshalbleiter eines Wechselrichters gehäusbildend umgibt und wärmeleitend mit den wärmeerzeugenden Leistungshalbleitern verbunden ist,
wobei das Gehäuse an seiner äußeren Oberfläche regelmäßig angeordnete, jeweils gleichförmige Erhebungen (2) aufweist,
wobei die Oberfläche derart gestaltet ist, dass an jedem Punkt der Oberfläche die Krümmung kleiner ist als ein maximaler Wert, wobei die Krümmung dem Kehrwert des Krümmungsradius entspricht und das Vorzeichen der Krümmung positiv ist, wenn eine Vertiefung vorliegt, und negativ ist, wenn eine Erhebung vorliegt, so dass flüssige Reinigungsmittel an jede Stelle der Oberfläche gelangen und von dort abfliessen können,
- wobei die Erhebungen (2) halbkugelförmig ausgeführt sind,
- oder wobei die Oberfläche wellenförmig ausgeführt ist, insbesondere in zwei zueinander senkrecht vorgesehenen Tangentialrichtungen der Grundfläche, also einer gedachten Grundfläche in den Bereichen der Erhebungen (2), die der Oberfläche entsoricht in Bereichen zwischen den Erhebungen (2),
- oder wobei die Oberfläche gleich ist zu einer Fläche, die durch z = sin(x) sin(y) oder z= sin(SQR(x^2+y^2))in einem kartesischen Koordinatensystem mit Koordinaten x, y und z definiert ist, wobei SQR die Wurzelfunktion ist

2. Gehäuse nach Anspruch 1,
**dadurch gekennzeichnet, dass**
das Gehäuseteil (1) mit wärmeerzeugenden Bauelementen wärmeleitend verbunden ist, insbesondere zur Wärmeabfuhr an die Umgebung, wobei das Gehäuse zumindest auch die Bauelemente gehäusebildend umgibt.

3. Gehäuse nach mindestens einem der vorangegangenen Ansprüche,
**dadurch gekennzeichnet, dass**
die Oberfläche derart gestaltet ist, dass an jedem Punkt der Oberfläche die Krümmung endlich ist.

4. Gehäuse nach mindestens einem der vorangegangenen Ansprüche,
**dadurch gekennzeichnet, dass**
**der Betrag des maximalen Wertes für konvexe und konkave Bereiche der Oberfläche gleich groß ist**.

5. Gerät mit einem Gehäuse nach mindestens einem der vorangegangenen Ansprüche,
**dadurch gekennzeichnet, dass**
das Gehäuse wärmeleitend mit wärmeerzeugenden Bauelementen verbunden ist, wobei das Gehäuse die Bauelemente gehäusebildend umgibt, insbesondere wobei die Bauelemente Leistungshalbleiter sind, insbesondere Leistungshableiter eines Wechselrichters.

6. Gerät nach mindestens einem der vorangegangenen Ansprüche,
**dadurch gekennzeichnet, dass**
das Gehäuseteil (1) ein Lager einer Rotorwelle eines vom Gehäuse umfassten Elektromotors und/oder ein Lager einer Abtriebswelle eines vom Gehäuse umfassten Getriebes umfasst.

7. Gerät nach mindestens einem der vorangegangenen Ansprüche,
**dadurch gekennzeichnet, dass**
über das Gehäuseteil (1) ein Stator, ein Rotor und/oder eine Getriebestufe entwärmbar sind.

8. Gerät nach mindestens einem der vorangegangenen Ansprüche,
**dadurch gekennzeichnet, dass**
die Oberfläche mit einer Antihaftbeschichtung zur Verringerung der Oberflächenspannung versehen ist.

9. Gerät nach Anspruch 8,
**dadurch gekennzeichnet, dass**
als Antihaftbeschichtung eine Fluorpolymerbeschichtung vorgesehen ist.

10. Gerät nach Anspruch 8 oder 9,
**dadurch gekennzeichnet, dass**
die Antihaftbeschichtung über einer Verstärkungsschicht und/oder Verbindungsschicht angeordnet ist, die auf dem Gehäuseteil (1), insbesondere Aluminium-Gehäuseteil oder Stahl-Gehäuseteil, aufgebracht ist oder sind.

## Claims

1. A housing, comprising at least one housing part (1), for use in the field of hygiene, for example in a wet area,
the housing surrounding the power semiconductors of an inverter in housing-forming manner and being connected to the heat-generating power semiconductors in heat-conducting manner,
the housing having on its outer surface regularly arranged elevations (2) which are uniform in each case,
the surface being configured such that at each point of the surface the curvature is less than a maximum value, the curvature corresponding to the reciprocal of the radius of curvature and the sign of the curvature being positive if an indentation is present and negative if an elevation is present, so that liquid cleaning agents can reach any point of the surface and flow away therefrom,
- the elevations (2) being made hemispherical,
- or the surface being made undulating, in particular in two tangential directions of the base surface which are provided perpendicular to each other, i.e, an imaginary base surface in the regions of the elevations (2), which corresponds to the surface in regions between the elevations (2),
- or the surface being equal to a surface which is defined by z = six(x) sin(y) or z = sin(SQR(x^2 +y^2)) in a Cartesian coordinate system with coordinates x, y and z, SQR being the root function.

2. A housing according to Claim 1,
**characterised in that**
the housing part (1) is connected in heat-conducting manner to heat-generating structural elements, in particular for dissipating heat to the surroundings, the housing at least also surrounding the structural elements in housing-forming manner.

3. A housing according to at least one of the preceding claims,
**characterised in that**
the surface is configured such that the curvature is finite at each point of the surface.

4. A housing according to at least one of the preceding claims,
**characterised in that**
the amount of the maximum value for convex and concave regions of the surface is of the same size.

5. An apparatus with a housing according to at least one of the preceding claims,
**characterised in that**
the housing is connected in heat-conducting manner to heat-generating structural elements, the housing surrounding the structural elements in housing-forming manner, in particular the structural elements being power semiconductors, in particular power semiconductors of an inverter.

6. An apparatus according to at least one of the preceding claims,
**characterised in that**
the housing part (1) comprises a bearing of a rotor shaft of an electric motor encompassed by the housing and/or a bearing of an output spindle of a transmission encompassed by the housing.

7. An apparatus according to at least one of the preceding claims,
**characterised in that**
a stator, a rotor and/or a gear stage can be cooled via the housing part (1).

8. An apparatus according to at least one of the preceding claims,
**characterised in that**
the surface is provided with a non-stick coating in order to reduce the surface tension.

9. An apparatus according to Claim 8,
**characterised in that**
a fluoropolymer coating is provided as non-stick coating.

10. An apparatus according to Claim 8 or 9,
**characterised in that**
the non-stick coating is arranged over a reinforcing layer and/or connecting layer which is or are applied to the housing part (1), in particular aluminium housing part or steel housing part.

## Revendications

1. Boîtier, comprenant au moins une partie de boîtier (1), pour une utilisation dans le domaine hygiénique, par exempte dans une zone humide,
sachant que le boîtier entoure les semi-conducteurs de puissance d'un onduleur en formant un boîtier et est relié en conduction thermique aux semi-conducteurs produisant de la chaleur,
sachant que le boîtier présente sur sa surface extérieure des bossages (2) régulièrement disposés, tous de même forme,
sachant que la surface est conçue de telle sorte que la courbure en tout point de la surface est inférieure à une valeur maximale, sachant que la courbure correspond à la valeur inverse du rayon de courbure et que le signe algébrique de la courbure est positif en présence d'un renfoncement et négatif en présence d'un bossage, de sorte que des produits de nettoyage liquides peuvent atteindre tous les points de la surface et s'en évacuer,
- sachant que les bossages (2) sont réalisés hémisphériques,
- ou sachant que la surface est réalisée ondulée, en particulier dans deux directions tangentielles, prévues perpendiculaires entre elles, de la surface de base, à savoir d'une surface de base imaginaire dans les régions des bossages (2) qui correspond à la surface dans les régions entre les bossages (2),
- ou sachant que la surface est égale à une surface qui est définie par z = sin(x) sin(y) ou z = sin(SQR(x^2 + y^2)) dans un système de coordonnées cartésiennes avec des coordonnées x, y et z, sachant que SQR est la fonction racine.

2. Boîtier selon la revendication 1, **caractérisé en ce que** la partie de boîtier (1) est reliée en conduction thermique à des composants produisant de la chaleur, en particulier pour évacuer la chaleur dans l'environnement, sachant que le boîtier entoure au moins également les composants en formant un boîtier.

3. Boîtier salon au moins une des revendications précédentes, **caractérisé en ce que** la surface est conçue de telle sorte que la courbure est finie en chaque point de la surface.

4. Boîtier selon au moins une des revendications précédentes, **caractérisé en ce que** le montant de la valeur maximale est identique pour les régions convexes et les régions concaves de la surface.

5. Appareil avec un boîtier selon au moins une des revendications précédentes, **caractérisé en ce que** le boîtier est relié en conduction thermique à des composants produisant de la chaleur, sachant que le boîtier entoure les composants en formant un boîtier, sachant notamment que les composants sont des semi-conducteurs, en particulier des semi-conducteurs d'un onduleur.

6. Appareil selon au moins une des revendications précédentes, **caractérisé en ce que** la partie de boîtier (1) comprend un palier d'un arbre de rotor d'un moteur électrique entouré par le boîtier, et/ou un palier d'un arbre de sortie d'une transmission entourée par le boîtier.

7. Appareil selon au moins une des revendications précédentes, **caractérisé en ce qu'**on peut évacuer par l'intermédiaire de la partie de boîtier (1) la chaleur d'un stator, d'un rotor et/ou d'un étage de transmission.

8. Appareil selon au moins une des revendications précédentes, **caractérisé en ce que** la surface est pourvue d'un revêtement empêchant l'adhérence, afin de réduire la tension superficielle.

9. Appareil selon la revendication 8, **caractérisé en ce qu'**un revêtement de polymère fluoré est prévu comme revêtement empêchant l'adhérence.

10. Appareil selon la revendication 8 ou 9, **caractérisé en ce que** le revêtement empêchant l'adhérence est disposé au-dessus d'une couche de renforcement et/ou d'une couche de liaison qui est ou sont apposée(s) sur la partie de boîtier (1), qui est notamment une partie de boîtier en aluminium ou une partie de boîtier en acier.
